Europäisches Patentamt

European Patent Office

Office européen des brevets

(11) Veröffentlichungsnummer: **0 142 666**

A2

(12) # EUROPÄISCHE PATENTANMELDUNG

(21) Anmeldenummer: **84111143.8**

(22) Anmeldetag: **19.09.84**

(51) Int. Cl.⁴: **C 30 B 29/06**

(30) Priorität: **20.09.83 DE 3333960**

(43) Veröffentlichungstag der Anmeldung:
**29.05.85 Patentblatt 85/22**

(84) Benannte Vertragsstaaten:
**DE FR IT**

(71) Anmelder: **Wacker-Chemitronic Gesellschaft für Elektronik-Grundstoffe mbH**
**Johannes-Hess-Strasse 24**
**D-8263 Burghausen(DE)**

(72) Erfinder: **Herzer, Heinz, Dr. Dipl.-Phys.**
**Immanuel-Kant-Strasse 49**
**D-8263 Burghausen(DE)**

(72) Erfinder: **Hensel, Wolfgang, Dipl.-Ing. (FH)**
**Elisabethstrasse 36**
**D-8263 Burghausen(DE)**

(72) Erfinder: **Matuszak, Günter**
**Mozartstrasse 11**
**D-8263 Burghausen(DE)**

(54) **Verfahren zur Herstellung von versetzungsfreien Einkristallstäben aus Silicium.**

(57) Es wird ein Verfahren zum tiegellosen Zonenziehen von Siliciumeinkristallen angegeben. Erfindungsgemäß wird als Vorratsstab anstelle eines durch Gasphasenabscheidung hergestellten, polykristallinen Siliciumstabes ein durch Tiegelziehen nach Czochralski erhaltener, polykristalliner Siliciumstab eingesetzt.

EP 0 142 666 A2

WACKER-CHEMITRONIC

Gesellschaft für Elektronik-
Grundstoffe mbH

München, den 6.6.1983
PAT/Dr.K/we    0142666

Wa-Ch 8209
==========

## Verfahren zur Herstellung von versetzungsfreien Einkristallstäben aus Silicium

Die Erfindung betrifft ein Verfahren zur Herstellung von versetzungsfreien Einkristallstäben aus Silicium durch tiegelloses Zonenziehen.

Um polykristallines Silicium, welches beispielsweise durch Zersetzung von Trichlorsilan auf erhitzten Trägerkörpern gewonnen wird, in einkristallines Silicium überzuführen, haben zwei Methoden besondere Bedeutung erlangt.

Beim Tiegelziehen nach Czochralski wird das polykristalline Material zerkleinert, in Quarztiegeln aufgeschmolzen und aus der Schmelze schließlich nach Animpfen ein Einkristall gezogen. Wegen der unvermeidlichen Reaktion zwischen Schmelze und Tiegelwand weisen die erhaltenen, versetzungsfreien Einkristalle stets einen beträchtlichen Anteil an Sauerstoff im Kristallgitter auf (vgl. z.B. DE-OS 27 58 888 bzw. US-PS 4 239 585) und werden daher vorzugsweise in der Mikroelektronik eingesetzt.

Beim tiegellosen Zonenziehen wird das als Vorratsstab dienende, polykristalline Material berührungslos, beispielsweise mittels einer Induktionsspule, an einer schmalen Stelle aufgeschmolzen. Diese Schmelzzone wird durch den Stab geführt, wobei das aufgeschmolzene Silicium nach Animpfen in einkristalliner Form wieder erstarrt. Zonengezogenes Material besitzt einen gegenüber tiegelgezogenem Material deutlich erniedrigten Sauerstoffanteil und einen hohen spezifischen Widerstand mit günstigem axialem Widerstandsverlauf; es eignet demgemäß insbesondere für Leistungsbauelemente.

Durch Zonenziehen lassen sich jedoch, wie in der DE-AS 20 12 086 dargelegt, versetzungsfreie Einkristallstäbe nicht in einem Arbeitsgang aus dem polykristallinen Material herstellen, sondern erst durch mindestens zweimaliges, entsprechend zeitraubendes Zonenschmelzen. Dabei ist insbesondere der erste Schmelzdurchgang des polykristallinen Siliciums wegen des ungleichmäßigen Aufschmelzverhaltens (Ausbildung von sogenannten "Nasen" oder "Spitzen", vgl. DE-OS 28 12 216) schwierig. Deshalb müssen auch die polykristallinen Stäbe unter bestimmten Bedingungen abgeschieden und überdies unter Materialverlust auf eine passende Größe zurechtgeschliffen werden.

Die Aufgabe der Erfindung war es daher, ein Verfahren anzugeben, das in demgegenüber kürzerer Zeit und besserer Ausbeute auf einfachere Weise die Herstellung von versetzungsfreien Einkristallstäben aus Silicium, insbesondere mit großen Durchmessern, durch Zonenziehen eines polykristallinen Vorratsstabes ermöglicht.

Gelöst wird diese Aufgabe durch ein Verfahren, welches dadurch gekennzeichnet ist, daß als Vorratsstab ein aus durch Gasphasenabscheidung erhaltenem Silicium tiegelgezogener, polykristalliner Siliciumstab eingesetzt wird.

Als Ausgangsmaterial für das Tiegelziehen des Vorratsstabes eignet sich grundsätzlich Silicium in jeder Form, sofern es die erforderliche Reinheit aufweist. Im allgemeinen wird man auf durch Zersetzung von Trichlorsilan auf erhitzten Trägerkörpern, z.B. aus Silicium oder Graphitfolie, erhältliches polykristallines Silicium zurückgreifen. Ein Vorteil gegenüber dem herkömmlichen Zonenziehverfahren liegt darin, daß im Hinblick auf günstiges Aufschmelzverhalten eine bestimmte Beschaffenheit des polykristallinen Materials nicht erforderlich ist. Daher ist z.B. eine genaue Einhaltung bestimmter Abscheidebedingungen nicht zwingend vorgeschrieben, so daß auch beispielsweise rasch abgeschiedenes Silicium eingesetzt werden kann, welches sich für den ersten Schmelzdurchgang beim üblichen Zonenziehprozeß nicht eignet. Ebenso können auch z.B. Abfallstücke zonengezogener Stäbe - allerdings nur unter Berücksichtigung ihrer Dotierung - verwendet werden, wodurch die Materialausnutzung verbessert wird.

Der eigentliche Tiegelziehprozeß, bei dem das vorgelegte, polykristalline Silicium aufgeschmolzen und zu einem Stab gezogen wird, wird in der dem Fachmann bekannten Weise durchgeführt. Eine umfassende Darstellung findet sich z.B. in dem Artikel "Czochralski-grown Silicon" von W. Zulehner und D. Huber, der in "Crystals", Vol. 8, (1982) Springer-Verlag, Berlin-Heidelberg-New York erschienen ist. Dort ist die Herstellung von Einkristallstäben, aber auch von Polykristallstäben, welche meist für sogenanntes "optisches" Silicium Verwendung finden, ausführlich erläutert.

Derartige polykristalline Stäbe lassen sich beim Tiegelziehen beispielsweise erhalten, wenn ein polykristalliner Impfkristall verwendet wird oder, bei Einsatz eines monokristallinen Impfkristalls, Versetzungen nicht z.B. durch sogenanntes "Flaschenhalsziehen" entfernt werden. Da beim Ziehvorgang lediglich auf Durchmesserkonstanz, nicht aber auf Versetzungsfreiheit, Monokristallinität und dergleichen geachtet werden muß, lassen sich auch hohe Ziehgeschwindigkeiten bis zu etwa 3,5 mm/Minute, bevorzugt 1,5 bis 2,5 mm/Minute erreichen.

Der polykristalline Stab wird zweckmäßig mit einem Durchmesser gezogen, der von dem des gewünschten einkristallinen, versetzungsfreien zonengezogenen Kristall möglichst wenig, im Höchstfalle um etwa 20 % abweicht. Bei grundsätzlich möglichen größeren Abweichungen ist es meist schwierig, die Mengen des aufschmelzenden und des rekristallisierenden Siliciums einander durch Nach- bzw. Wegführen der entsprechenden Stabteile anzupassen.

Vorteilhaft wird·der polykristalline Stab so gezogen,
daß an seinem Ende eine wulstartige Verdickung entsteht,
mit deren Hilfe er sich beim anschließenden Zonenziehen
in einer dafür vorgesehenen Halterung befestigen läßt.

Der polykristalline Stab zeigt ein günstiges Aufschmelzverhalten, wenn er im Querschnitt keine zu großen einkristallinen Bereiche aufweist. Vorteilhaft ist daher anzustreben, daß die Fläche der einzelnen, im Stabquerschnitt
auftretenden und erkennbaren einkristallinen Bereiche stets
weniger als etwa ein Drittel der gesamten Querschnittsfläche beträgt. Beispielsweise lassen sich polykristalline
Stäbe mit 100 mm Durchmesser problemlos aufschmelzen, wenn
ihre Querschnittsfläche im wesentlichen aus Einkristallbereichen von 1 bis 400 mm² Fläche zusammengesetzt ist.

Im Anschluß an den Tiegelziehvorgang wird der erhaltene
polykristalline Siliciumstab in der bekannten und dem Fachmann geläufigen Weise dem Zonenziehprozeß unterworfen (vgl.
z.B. W. Dietze, W. Keller, A. Mühlbauer, "Floatzone grown
silicon" in "Crystals" Vol. 5 (1981)·Springer-Verlag, Berlin-
Heidelberg-New York).

In einer günstigen Ausführungsform des erfindungsgemäßen
Verfahrens wird der polykristalline Stab mit dem an einem
Ende befindlichen Ringwulst an der oberen Ziehwelle einer
üblichen Zonenziehanlage als Vorratsstab befestigt. Nach
dem Ansetzen des Impfkristalls wird in einem Zug unter
einem Schutzgasdruck von vorzugsweise 1,4 bis 2,5 bar ein
Einkristallstab des gewünschten Durchmessers gezogen. Grundsätzlich kann das Verfahren auch unter Normaldruck durchgeführt werden; als Schutzgase eignen sich z.B. Argon, Wasserstoff oder Stickstoff, und zwar einzeln oder im Gemisch.

Bei diesem Prozeß entgast größtenteils der in dem Vorratsstab enthaltene Sauerstoff als Siliciummmonoxid, so daß ein
Produkt mit einem Restgehalt an Sauerstoff von typisch unter

$1 \cdot 10^{16}$ Atome/cm$^3$, ähnlich dem des in herkömmlicher Weise zonengezogenen Siliciums, erhalten wird.

Durch Zugabe von Dotiergas kann der Stab während des Zonenziehvorganges dotiert werden, wobei günstig ein undotierter Vorratsstab eingesetzt wird. Bei dotiertem Vorratsstab kann der im allgemeinen für tiegelgezogenes Material typische starke axiale Widerstandsabfall durch variabel zugegebenes Dotiergas korrigiert und ausgeglichen werden. Durch dieses, insbesondere bei Phosphordotierung günstige Verfahren läßt sich ein axialer Widerstandsverlauf erreichen, der dem ausschließlich zonengezogener Einkristalle vergleichbar ist.

Das erfindungsgemäße Verfahren eignet sich besonders für die Herstellung von Stäben mit großen Durchmessern. Grundsätzlich kann auf alle Stabdurchmesser zurückgegriffen werden, die sich beim Tiegelziehen realisieren lassen. Vorzugsweise werden als Vorratsstäbe die durch Tiegelziehen leicht zugänglichen polykristallinen Siliciumstäbe mit Durchmessern von mindestens 100 mm eingesetzt.

Damit wird es ermöglicht, durch nur einmaliges Zonenziehen, ausgehend von einem polykristallinen Siliciumstab, versetzungsfreie einkristalline Siliciumstäbe mit Durchmessern von 100 bis 125 mm und mehr herzustellen. Diese weisen eine gegenüber dem ausschließlich tiegelgezogenen Material deutlich verbesserte axiale Widerstandsverteilung und verminderten Sauerstoffgehalt auf. Ein weiterer Vorteil des erfindungsgemäßen Verfahrens liegt in dem gegenüber der Gasphasenabscheidung, gefolgt von zwei Zonenziehdurchgängen, für je einen Abscheide-, Tiegelzieh- und Zonenziehdurchgang verringerten Zeitbedarf, sowie in der Möglichkeit, beim Zonenziehprozeß anfallendes Abfallmaterial einer Nutzung zuzuführen.

## Ausführungsbeispiel

In einer handelsüblichen Apparatur zum Tiegelziehen nach Czochralski wurden etwa 26 kg durch Zersetzung von Trichlorsilan erhaltenes, grobstückiges, undotiertes Silicium eingeschmolzen. Aus der Schmelze wurde nach Animpfen mit einem polykristallinen Impfkristall (Durchmesser 6 mm, Länge 50 mm ) ein polykristalliner Stab (Durchmesser etwa 100 mm, Ziehgeschwindigkeit etwa 2,0 mm/Minute) gezogen. Am Ende des Ziehvorganges wurde die Ziehgeschwindigkeit kurzfristig etwas reduziert, um das Stabende wulstartig zu verdicken.

Der erhaltene, polykristalline Stab wurde an beiden Enden auf die passende Länge zurechtgeschnitten (Gewicht nunmehr ca. 24,6 kg) und anschließend mit dem Wulst nach oben an der Ziehwelle einer handelsüblichen Zonenziehanlage für die Herstellung von einkristallinen Halbleiterstäben befestigt. Anschließend wurde der Rezipient mit Hilfe einer handelsüblichen Vakuumpumpe evakuiert und mit einem Wasserstoff-Argon-Gasgemisch bis zu einem Gesamtdruck von 1,5 bar gefüllt. Nach dem Ansetzen eines Impfkristalls wurde eine mittels einer Induktionsheizspule erzeugte schmale Schmelzzone mit einer Geschwindigkeit von 3 mm/Minute über die gesamte Länge durch den Stab geführt.

Es wurde ein versetzungsfreier Siliciumeinkristall mit 100 mm Durchmesser erhalten. Weder mit Ätztechniken noch mit röntgenographischen Methoden ließen sich Kristallfehler nachweisen.

0142666

P a t e n t a n s p r ü c h e

1. Verfahren zur Herstellung von Einkristallstäben aus
   Silicium durch tiegelloses Zonenziehen, d a d u r c h
   g e k e n n z e i c h n e t , daß als Vorratsstab ein
   aus durch Gasphasenabscheidung erhaltenem Silicium tiegelgezogener, polykristalliner Siliciumstab eingesetzt wird.

2. Verfahren nach Anspruch 1, d a d u r c h g e k e n n -
   z e i c h n e t , daß der Durchmesser des Vorratsstabes
   so gewählt wird, daß er sich von dem des gewünschten
   Einkristallstabes um höchstens 20 % unterscheidet.

3. Verfahren nach den Ansprüchen 1 oder 2, d a d u r c h
   g e k e n n z e i c h n e t , daß der polykristalline
   Vorratsstab an einem Ende mit einer wulstartigen Verdickung versehen wird.

4. Verfahren nach einem oder mehreren der Ansprüche 1 bis 3,
   d a d u r c h g e k e n n z e i c h n e t , daß ein
   Vorratsstab mit einem Durchmesser von mindestens 100 mm
   ausgewählt wird.

5. Verfahren nach einem oder mehreren der Ansprüche 1 bis 4,
   d a d u r c h g e k e n n z e i c h n e t , daß der
   Vorratsstab mit einer Geschwindigkeit von 1,5 bis 2,5 mm/
   Minute gezogen wird.

6. Verwendung von durch Tiegelziehen nach Czochralski hergestellten polykristallinen Siliciumstäben als Vorratsstäbe bei der Herstellung versetzungsfreier Einkristallstäbe durch einmaliges Zonenziehen.